# EUROPEAN PATENT APPLICATION

(11) **EP 4 852 660 A1**
(43) Date of publication of application: **09.12.2026**
(21) Application number: 26181949.4
(22) Date of filing: 29.05.2026
(51) Int. Cl.: H10F 19/80, B32B 7/02

(54) **ENCAPSULATING FILM AND PHOTOVOLTAIC MODULE**

(30) Priority: 05.06.2025 CN 202510748781
(71) Applicant: Tongwei Solar (Chengdu) Co., Ltd., Chengdu, Sichuan 610299 (CN)
(72) Inventor: GU, Wenjun, Chengdu, 610299 (CN); YAN, Dengzhou, Chengdu, 610299 (CN); JI, Wei, Chengdu, 610299 (CN); YANG, Zhiqiang, Chengdu, 610299 (CN); WANG, Yuhan, Chengdu, 610299 (CN); XIA, Zhengyue, Chengdu, 610299 (CN); XING, Guoqiang, Chengdu, 610299 (CN)
(74) Representative: Murgitroyd & Company

(57) **Abstract**

An encapsulating film includes at least a first adhesive film layer, a second adhesive film layer and a third adhesive film layer arranged in sequence. A content of an ultraviolet (UV) absorber in the first adhesive film layer is different from a content of the UV absorber in the third adhesive film layer, and the second adhesive film layer is configured to block diffusion of the UV absorber from the first adhesive film layer and/or the third adhesive film layer.

## Description

### TECHNICAL FIELD

The present invention relates to the field of photovoltaic technologies, and in particular, to an encapsulating film and a photovoltaic module.

### BACKGROUND

As conventional fossil fuels are increasingly depleted, solar energy is undoubtedly the cleanest, most universal, and most promising alternative energy source among existing sustainable energy sources. A solar power generation apparatus, also known as a solar cell or a photovoltaic cell, can directly convert the solar energy into electrical energy, and its power generation principle is based on a photovoltaic effect of a semiconductor PN junction.

The photovoltaic cell faces numerous challenges in practical applications, one of the main difficulties being ultraviolet (UV) light-induced degradation. Taking a heterojunction (HJT) cell and a tunnel oxide passivated contact (TOPCon) cell as examples, ultraviolet light destroys a silicon-hydrogen bond (Si-H) in the cells, leading to passivation failure, and thus reducing cell efficiency. A conventional solution includes using a UV-cutoff encapsulating film containing a UV absorber. However, during the use and testing of the encapsulating film containing the UV absorber, it has been found that the encapsulating film containing the UV absorber is prone to yellowing.

### SUMMARY

Based on this, it is necessary to solve the problem in the above related art by providing an encapsulating film and a photovoltaic module, which at least avoids yellowing of the film, thereby improving a service life of the encapsulating film, and thus enhancing the efficiency of the photovoltaic module.

To achieve the above purpose and other related purposes, in an aspect of the present invention, an encapsulating film is provided, which includes at least a first adhesive film layer, a second adhesive film layer and a third adhesive film layer arranged in sequence. A content of an ultraviolet (UV) absorber in the first adhesive film layer is different from a content of the UV absorber in the third adhesive film layer, and the second adhesive film layer is configured to block diffusion of the UV absorber from the first adhesive film layer and/or the third adhesive film layer.

In an embodiment, the third adhesive film layer is configured to bond to a solar cell, the first adhesive film layer is arranged on a side of the second adhesive film layer away from the solar cell, and the content of the UV absorber in the first adhesive film layer is greater than the content of the UV absorber in the third adhesive film layer.

In an embodiment, the content of the UV absorber in the first adhesive film layer is greater than 90% of a total content of the UV absorber in the encapsulating film, and the content of the UV absorber in the third adhesive film layer is less than 10% of the total content of the UV absorber in the encapsulating film.

In an embodiment, the content of the UV absorber in the first adhesive film layer is 100% of a total content of the UV absorber in the encapsulating film, and the content of the UV absorber in the third adhesive film layer is 0.

In one embodiment, the UV absorber includes functional groups for absorbing ultraviolet light, and the functional groups for absorbing an ultraviolet light including at least one of an o-hydroxybenzoate functional group, an azo functional group, a carbonyl functional group, and an imino functional group; and preferably
the UV absorber includes at least one of a salicylic acid, a benzotriazole, a benzophenone, and a triazine.

In an embodiment, the encapsulating film also includes an alkaline antacid agent.

In an embodiment, the alkaline antacid agent includes at least one of a magnesium oxide, an aluminum oxide, a zinc oxide, a barium sulfate, and a titanium oxide; and preferably
the third adhesive film layer is configured to bond to a solar cell, the first adhesive film layer is arranged on a side of the second adhesive film layer away from the solar cell, and a content of the alkaline antacid agent in the third adhesive film layer is greater than a content of the alkaline antacid agent in the first adhesive film layer.

In an embodiment, the content of the alkaline antacid agent in the third adhesive film layer is greater than 90% of a total content of the alkaline antacid agent in the encapsulating film, and the content of the alkaline antacid agent in the first adhesive film layer is less than 10% of the total content of the alkaline antacid agent in the encapsulating film.

In one embodiment, the content of the alkaline antacid agent in the third adhesive film layer is 100% of a total content of the alkaline antacid agent in the encapsulating film, and the content of the alkaline antacid agent in the first adhesive film layer is 0.

In an embodiment, the first adhesive film layer and the third adhesive film layer have a same polarity as the UV absorber, and the second adhesive film layer has a different polarity from the UV absorber; and preferably
the first adhesive film layer, the third adhesive film layer and the UV absorber are polar substances, and the second adhesive film layer is a non-polar substance.

In one embodiment, a main component of the first adhesive film layer and the third adhesive film layer includes an ethylene-vinyl acetate copolymer, and a main component of the second adhesive film layer includes a polyolefin elastomer.

In an embodiment, a raw material formulation of the first adhesive film layer includes, by mass percentage: 93%~96% of an ethylene-vinyl acetate copolymer, 0.5%~3% of the UV absorber, 0.5%v1% of an antioxidant, 0.8%~1% of a heat stabilizer, 0.5%~1.5% of a silane coupling agent, 0.5%~0.8% of a crosslinking agent, 0%~0.5% of a tackifying resin, and 0%~1.5% of a plasticizer.

In an embodiment, a raw material formulation of the third adhesive film layer includes, by mass percentage: 93%~96% of an ethylene-vinyl acetate copolymer, 1.5%~2% of an alkaline antacid agent, 0.5%~1% of an antioxidant, 0.8%~1% of a heat stabilizer, 0.5%~1.5% of a silane coupling agent, 0.5%~0.8% of a crosslinking agent, 0%~0.5% of a tackifying resin, and 0%~1.5% of a plasticizer.

In an embodiment, a raw material formulation of the second adhesive film layer includes, by mass percentage: 93%~97% of a polyolefin elastomer, 0.5%~1% of an antioxidant, 0.8%~1% of a heat stabilizer, 0.5%~1.5% of a silane coupling agent, 0.5%~0.8% of a crosslinking agent, 0%~0.5% of a tackifying resin, and 0%~1.5% of a plasticizer.

Another aspect of the present invention provides a photovoltaic module, including a front glass, a front encapsulating film, a solar cell, a back encapsulating film, and a backsheet arranged in sequence. The front encapsulating film and/or the back encapsulating film includes the encapsulating film according to any of the above embodiments.

According to the encapsulating film and photovoltaic module provided by the present invention, by making the content of the UV absorber different in different adhesive film layers of the encapsulating film, and arranging an adhesive film layer for blocking diffusion of the UV absorber between the different adhesive film layers containing the UV absorber, the UV absorber is prevented from contacting with other components in the encapsulating film that may chemically react with or catalyze the UV absorber, thereby preventing yellowing of the encapsulating film, and thus improving a service life of the encapsulating film, and enhancing the efficiency of the photovoltaic module.

### BRIEF DESCRIPTION OF THE DRAWINGS

In order to better describe and illustrate embodiments and/or examples of the application disclosed herein, reference may be made to one or more accompanying drawings. The additional details or examples used for describing the accompanying drawings should not be considered as limiting the scope of any of the disclosed application, the presently described embodiments and/or examples, and the best mode of these applications as presently understood.
FIG. 1 is a schematic structural diagram of an encapsulating film provided in an embodiment.
FIG. 2 is a schematic structural diagram of another encapsulating film provided in an embodiment.
FIG. 3 is a schematic structural diagram of yet another encapsulating film provided in an embodiment.
FIG. 4 is a schematic structural diagram of still another encapsulating film provided in an embodiment.
FIG. 5 is a schematic structural diagram of a photovoltaic module provided in an embodiment.

Reference symbols:
100: encapsulating film; 110: first adhesive film layer; 120: second adhesive film layer; 130: third adhesive film layer; 200: UV absorber; 300: alkaline antacid agent; 400: metal ion; 500: photovoltaic module; 510: front glass; 520: front encapsulating film; 530: solar cell; 540: back encapsulating film; 550: backsheet.

### DETAILED DESCRIPTION OF THE EMBODIMENTS

In order to facilitate to understanding the present invention, the present invention will be described more comprehensively below with reference to the relevant accompanying drawings. Preferred embodiments of the present invention are shown in the drawings. However, the present invention may be implemented in many different forms, and is not limited to the embodiments described herein. On the contrary, these embodiments are provided so that the disclosure of the present invention will be more thorough and comprehensive.

Unless otherwise defined, all technical and scientific terms used herein have the same meaning as commonly understood by one with ordinary skill in the art to which this application belongs. The terminology used herein in the description of the present invention is for the purpose of describing particular embodiments only, and is not intended to limit the present invention. The term "and/or" as used herein includes any and all combinations of one or more of the associated listed items.

The terminology used herein is for the purpose of describing particular embodiments only, and is not intended as a limitation of the present invention. As used herein, the singular forms "a", "an", and "the" are intended to include the plural forms as well, unless the context clearly indicates otherwise. It will also be understood that the terms "comprising" and/or "including", when used in this specification, specify the presence of stated features, integers, steps, operations, elements, and/or components, but do not preclude the presence or addition of one or more other features, integers, steps, operations, elements, components, and/or groups thereof. As used herein, the term "and/or" includes any and all combinations of the associated listed items.

It should be noted that the diagrams provided in the present embodiments are only intended to illustrate the basic concept of the present invention in a schematic manner. Although the diagrams only show components related to the present invention rather than being drawn according to the number, shape, and size of components in actual implementation, the type, quantity, and proportion of each component in actual implementation may be arbitrarily changed, and the component layout may also be more complex.

A photovoltaic cell faces numerous challenges in practical applications, one of the main difficulties being ultraviolet light-induced degradation. Taking a heterojunction (HJT) cell and a tunnel oxide passivated contact (TOPCon) cell as examples, ultraviolet light destroys a silicon-hydrogen bond (Si-H) in the cells, leading to passivation failure, and thus reducing cell efficiency. A conventional solution includes using a UV-cutoff encapsulating film containing a UV absorber. After absorbing high-energy ultraviolet light, a molecular structure of the UV absorber changes to form a unique resonance form, releasing heat during the process of returning to the initial state, thereby achieving light-to-heat conversion. However, during the use and testing of the encapsulating film containing the UV absorber, it has been found that the encapsulating film containing the UV absorber is prone to yellowing.

Research and analysis on the problem that the encapsulating film containing a UV absorber is prone to yellowing during use and testing have revealed that the yellowing of the encapsulating film is caused by a chemical reaction between other components in the encapsulating film and the UV absorber, or by catalysis on the UV absorber due to other components in the encapsulating film. Depending on a type of a functional group used for absorbing ultraviolet light, the components that chemically react with or catalyze the UV absorber also differ. For example, when a substance containing an o-hydroxybenzoate functional group is used as the UV absorber, the presence of alkaline substances in the encapsulating film leads to the yellowing of the encapsulating film. When a substance containing an azo functional group is used as the UV absorber, the presence of metal ions in the encapsulating film leads to the yellowing of the film.

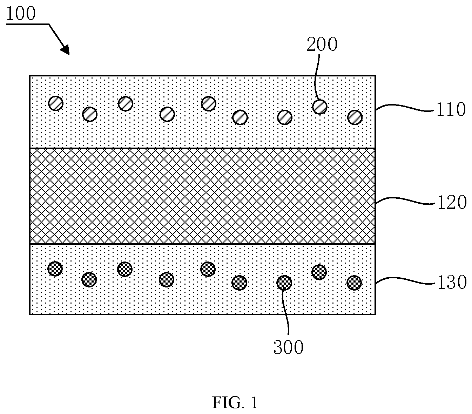

In view of the above problems, the present invention provides an encapsulating film. As shown in FIG. 1 to FIG. 4, the encapsulating film 100 includes at least a first adhesive film layer 110, a second adhesive film layer 120 and a third adhesive film layer 130 arranged in sequence. A content of a UV absorber 200 in the first adhesive film layer 110 is different from a content of the UV absorber 200 in the third adhesive film layer 130, and the second adhesive film layer 120 is configured to block diffusion of the UV absorber 200 from the first adhesive film layer 110 and/or the third adhesive film layer 130.

In an embodiment, the UV absorber 200 includes functional groups for absorbing ultraviolet light, and the functional groups for absorbing the ultraviolet light include, but are not limited to, at least one of an o-hydroxybenzoate functional group (-OH ortho to -COOR), an azo functional group (N=N), a carbonyl functional group (C=O), and an imino functional group (C=N).

In an embodiment, the UV absorber 200 includes, but is not limited to, at least one of salicylic acid (C₇H₆O₃), benzotriazole (C₆H₅N₃), benzophenone (C₁₃H₁₀O), and triazine (C₃H₃N₃). Among them, the salicylic acid (C₇H₆O₃) includes an o-hydroxybenzoate functional group (-OH ortho to -COOR), the benzotriazole (C₆H₅N₃) includes an azo functional group (N=N), the benzophenone (C₁₃H₁₀O) includes a carbonyl functional group (C=O), and the triazine (C₃H₃N₃) includes an imino functional group (C=N).

In an embodiment, different types of the UV absorbers 200 may be used for absorbing the ultraviolet light in different wavelength bands. For example, a first type of the UV absorber is used for absorbing long-wave ultraviolet (UVA) with a wavelength ranging from 315 nm to 400 nm, a second type of the UV absorber is used for absorbing medium-wave ultraviolet (UVB) with a wavelength ranging from 280 nm to 315 nm, and a third type of the UV absorber is used for absorbing short-wave ultraviolet (UVC) with a wavelength ranging from 100 nm to 280 nm.

In an embodiment, the encapsulating film 100 further includes a yellowing-causing component which chemically reacts with the UV absorber 200 or has a catalytic effect on the UV absorber 200, causing yellowing of the encapsulating film 100. Therefore, in the encapsulating film 100 provided by the present invention, the UV absorber 200 and the yellowing-causing component should be located in different adhesive film layers of the encapsulating film 100. In some cases, if both the UV absorber 200 and the yellowing-causing component are essential components or unavoidable components of an adhesive film layer, the contents of the UV absorber 200 and the yellowing-causing component in the adhesive film layer are adjusted. For example, when the content of the UV absorber 200 in one adhesive film layer is relatively high, the content of the yellowing-causing component in that adhesive film layer is reduced; or, when the content of the UV absorber 200 in one adhesive film layer is relatively low, the content of the yellowing-causing component in that adhesive film layer is increased. Through the above adjustments, both the content of the UV absorber 200 and the content of the yellowing-causing component in the entire encapsulating film 100 meet the requirements. After the above adjustments, the content of the UV absorber 200 in the first adhesive film layer 110 of the encapsulating film 100 is different from the content of the UV absorber 200 in the third adhesive film layer 130.

In an embodiment, when the content of the UV absorber 200 in the first adhesive film layer 110 is different from the content of the UV absorber 200 in the third adhesive film layer 130, it is necessary to provide an adhesive film layer for blocking diffusion of the UV absorber 200 between the first adhesive film layer 110 and the third adhesive film layer 130, that is, the second adhesive film layer 120.

In an optional embodiment, according to the principle of " similarity-intermiscibility", the first adhesive film layer 110 and the third adhesive film layer 130 have a same polarity as the UV absorber 200, and the second adhesive film layer 120 has a different polarity from the UV absorber 200. Since the UV absorber 200 is a polar substance, in the present embodiment, the first adhesive film layer 110 and the third adhesive film layer 130 may be made of polar substances, such as ethylene-vinyl acetate copolymer (EVA), and the second adhesive film layer 120 may be made of a non-polar substance, such as a polyolefin elastomer (POE).

Exemplarily, the third adhesive film layer 130 is configured to bond to a solar cell, the first adhesive film layer 110 is disposed on a side of the second adhesive film layer 120 away from the solar cell, the content of the UV absorber 200 in the first adhesive film layer 110 is greater than the content of the UV absorber 200 in the third adhesive film layer 130, and the content of the yellowing-causing component in the first adhesive film layer 110 is less than the content of the yellowing-causing component in the third adhesive film layer 130.

In an embodiment, when an adhesive film layer of the encapsulating film includes an ethylene-vinyl acetate copolymer (EVA) adhesive film layer, the EVA adhesive film layer will decompose in a hot and humid environment and produce acetic acid, the acetic acid will damage an electrode of the solar cell, thereby reducing cell efficiency. Therefore, an alkaline antacid agent 300 needs to be added to the EVA adhesive film layer to neutralize the acetic acid generated in the hot and humid environment. However, the alkaline antacid agent 300 is a yellowing-causing component corresponding to the UV absorber 200 such as salicylic acid, which includes an o-hydroxybenzoate functional group (-OH ortho to -COOR).

In an embodiment, when the encapsulating film 100 includes an EVA adhesive film layer, it needs to include both the UV absorber 200 and the alkaline antacid agent 300. In order to avoid damage to the solar cell caused by the acetic acid generated by the decomposition of the EVA adhesive film layer in the hot and humid environment, the alkaline antacid agent 300 is an essential component in the third adhesive film layer 130 that is bonded to the solar cell. Therefore, the content of the UV absorber 200 in the third adhesive film layer 130 may be reduced to avoid yellowing.

Optionally, in order to ensure an overall UV-cutoff effect of the encapsulating film 100, while minimizing the content of the UV absorber 200 in the third adhesive film layer 130, the content of the UV absorber 200 in the first adhesive film layer 110 is correspondingly increased, so that the total content of the UV absorber 200 in the encapsulating film 100 remains unchanged. Furthermore, since the first adhesive film layer 110 is arranged on the side of the second adhesive film layer 120 away from the solar cell, ultraviolet light first passes through the first adhesive film layer 110, then sequentially passes through the second adhesive film layer 120 and the third adhesive film layer 130, and then irradiates onto the surface of the solar cell. By increasing the content of the UV absorber 200 in the first adhesive film layer 110, the ultraviolet light (UV) is cut off when it first irradiates onto the first adhesive film layer 110 of the encapsulating film 100, thereby avoiding damage to the second adhesive film layer 120 and the third adhesive film layer 130 caused by the ultraviolet light.

Taking an encapsulating film where the content of the UV absorber 200 in the first adhesive film layer 110 is the same as the content of the UV absorber 200 in the third adhesive film layer 130 as a comparative encapsulating film.

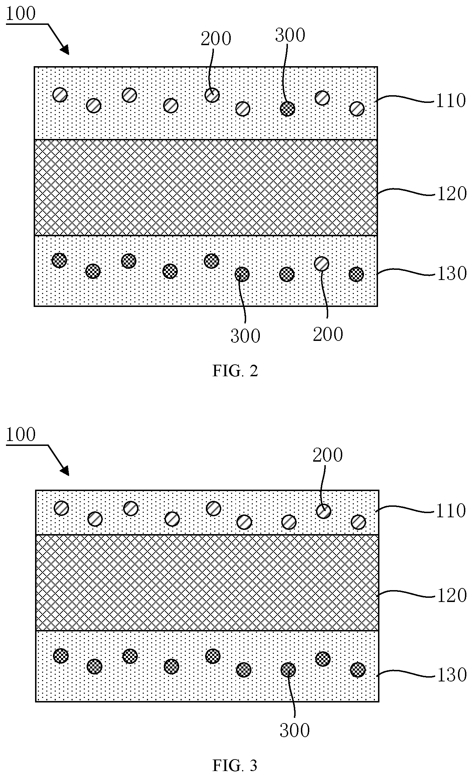

Optionally, the first adhesive film layer 110 and the third adhesive film layer 130 are produced through a same equipment/production line. An ethylene vinyl acetate (EVA) adhesive film layer produced in a same batch may be used as both the first adhesive film layer 110 and the third adhesive film layer 130. Therefore, the content of the UV absorber 200 in the first adhesive film layer 110 is the same as the content of the UV absorber 200 in the third adhesive film layer 130, and the content of the alkaline antacid agent 300 therein is also the same. Taking an encapsulating film where the content of the UV absorber 200 in the first adhesive film layer 110 is different from the content of the UV absorber 200 in the third adhesive film layer 130 according to an embodiment of the present invention as an improved encapsulating film. Optionally, the first adhesive film layer 110 and the third adhesive film layer 130 are produced through the same equipment/production line, but cannot be produced simultaneously. When producing the first adhesive film layer 110, the UV absorber 200 is added and the alkaline antacid agent 300 is not added, so that the content of the UV absorber 200 in the first adhesive film layer 110 is greater than 90% of the total content of the UV absorber 200 in the encapsulating film 100, and the content of the alkaline antacid agent 300 is less than 10% of the total content of the alkaline antacid agent 300 in the encapsulating film 100, as shown in FIG. 2. When producing the third adhesive film layer 130, the alkaline antacid agent 300 is added and the UV absorber 200 is not added, so that the content of the alkaline antacid agent 300 in the third adhesive film layer 130 is greater than 90% of the total content of the alkaline antacid agent 300 in the encapsulating film 100, and the content of the UV absorber 200 is less than 10% of the total content of the UV absorber 200 in the encapsulating film 100, as shown in FIG. 2.

Optionally, the first adhesive film layer 110 and the third adhesive film layer 130 are produced through different equipment/production lines. When producing the first adhesive film layer 110, the UV absorber 200 is added and the alkaline antacid agent 300 is not added, so that the content of the UV absorber 200 in the first adhesive film layer 110 is 100% of the total content of the UV absorber 200 in the encapsulating film 100, and the content of the alkaline antacid agent 300 in the first adhesive film layer 110 is 0, as shown in FIG. 1. When producing the third adhesive film layer 130, the alkaline antacid agent 300 is added and the UV absorber 200 is not added, so that the content of the alkaline antacid agent 300 in the third adhesive film layer 130 is 100% of the total content of the alkaline antacid agent 300 in the encapsulating film 100, and the content of the UV absorber 200 in the third adhesive film layer 130 is 0, as shown in FIG. 1.

In an embodiment, a thickness of the first adhesive film layer 110 and a thickness of the third adhesive film layer 130 may be the same (as shown in FIG. 1 and FIG. 2). In another embodiment, the thickness of the first adhesive film layer 110 and the thickness of the third adhesive film layer 130 may be different (as shown in FIG. 3). The thickness of the first adhesive film layer 110 ranges from 50 µm to 200 µm, for example, 50 µm, 80 µm, 150 µm or 200 µm. The thickness of the third adhesive film layer 130 is greater than or equal to the thickness of the first adhesive film layer 110. In the embodiments shown in FIG. 1 and FIG. 2, the thickness of the third adhesive film layer 130 is equal to the thickness of the first adhesive film layer 110. In the embodiment shown in FIG. 3, the thickness of the third adhesive film layer 130 is greater than the thickness of the first adhesive film layer 110. The thickness of the third adhesive film layer 130 ranges from 100 µm to 200 µm, for example, 100 µm, 150 µm or 200 µm. As shown in FIG. 1 to FIG. 3, the thickness of the second adhesive film layer 120 is greater than the thickness of the first adhesive film layer 110 and the thickness of the third adhesive film layer 130. The thickness of the second adhesive film layer 120 ranges from 150 µm to 250 µm, for example, 150 µm, 190 µm or 250 µm.

In an embodiment, a raw material formulation of the first adhesive film layer 110 includes ethylene-vinyl acetate copolymer (EVA), the UV absorber 200, antioxidant, heat stabilizer, silane coupling agent, and crosslinking agent. Optionally, the raw material formulation of the first adhesive film layer 110 also includes a tackifying resin and/or a plasticizer. The UV absorber 200 includes, but is not limited to, salicylic acid. The antioxidant includes, but is not limited to, phenolic antioxidants, phosphite antioxidants, and the like. The heat stabilizer includes, but is not limited to, phosphite heat stabilizers, fatty acid salt heat stabilizers, epoxy compound heat stabilizers, hindered amine heat stabilizers, and the like. The silane coupling agent includes, but is not limited to, methacryloxy silane coupling agents, vinyl silane coupling agents, epoxy silane coupling agents, and the like. The crosslinking agent includes, but is not limited to, olefinic co-crosslinking agents, peroxide co-crosslinking agents, silane co-crosslinking agents, and the like. The tackifying resin includes, but is not limited to, terpene resins, petroleum resins, styrenic copolymer resins, phenolic resins, and the like. The plasticizer includes phthalate plasticizers, epoxy compound plasticizers, polyester plasticizers, and the like.

In an embodiment, the raw material formulation of the first adhesive film layer 110 includes, by mass percentage: 93%~96% of ethylene-vinyl acetate copolymer (EVA), for example, 93%, 94.5% or 96%; 0.5%~3% of UV absorber 200, for example, 0.5%, 2% or 3%; 0.5%~1% of antioxidant, for example, 0.5%, 0.8% or 1%; 0.8%~1% of heat stabilizer, for example, 0.8%, 0.9% or 1%; 0.5%~1.5% of silane coupling agent, for example, 0.5%, 1% or 1.5%; 0.5%~0.8% of crosslinking agent, for example, 0.5%, 0.6% or 0.8%; 0%~0.5% of tackifying resin, for example, 0%, 0.3% or 0.5%; and 0~1.5% of plasticizer, for example, 0%, 0.5% or 1.5%.

In an embodiment, a raw material formulation of the third adhesive film layer 130 includes ethylene-vinyl acetate copolymer (EVA), the alkaline antacid agent 300, antioxidant, heat stabilizer, silane coupling agent, and crosslinking agent. Optionally, the raw material formulation of the third adhesive film layer 130 also includes a tackifying resin and/or a plasticizer. The alkaline antacid agent 300 includes, but is not limited to, at least one of magnesium oxide, aluminum oxide, zinc oxide, barium sulfate, and titanium oxide.

In an embodiment, the raw material formulation of the third adhesive film layer 130 includes, by mass percentage: 93%~96% of ethylene-vinyl acetate copolymer (EVA), for example, 93%, 94.5% or 96%; 1.5%~2% of alkaline antacid agent 300, for example, 1.5%, 1.8% or 2%; 0.5%~1% of antioxidant, for example, 0.5%, 0.8% or 1%; 0.8%~1% of heat stabilizer, for example, 0.8%, 0.9% or 1%; 0.5%~1.5% of silane coupling agent, for example, 0.5%, 1% or 1.5%; 0.5%~0.8% of crosslinking agent, for example, 0.5%, 0.6% or 0.8%; 0~0.5% of tackifying resin, for example, 0%, 0.3% or 0.5%; and 0~1.5% of plasticizer, for example, 0%, 0.5% or 1.5%.

In an embodiment, a raw material formulation of the second adhesive film layer 120 includes polyolefin elastomer (POE), antioxidant, heat stabilizer, silane coupling agent, and crosslinking agent. Optionally, the raw material formulation of the second adhesive film layer 120 also includes a tackifying resin and/or a plasticizer.

In an embodiment, the raw material formulation of the second adhesive film layer 120 includes, by mass percentage: 93%~97% of polyolefin elastomer (POE), for example, 93%, 94.5% or 97%; 0.5%~1% of antioxidant, for example, 0.5%, 0.8% or 1%; 0.8%~1% of heat stabilizer, for example, 0.8%, 0.9% or 1%; 0.5%~1.5% of silane coupling agent, for example, 0.5%, 1% or 1.5%; 0.5%~0.8% of crosslinking agent, for example, 0.5%, 0.6% or 0.8%; 0%~0.5% of tackifying resin, for example, 0%, 0.3% or 0.5%; and 0%~1.5% of plasticizer, for example, 0%, 0.5% or 1.5%.

In an embodiment, a yellowing test is performed on the encapsulating film 100 formed by the first adhesive film layer 110, the second adhesive film layer 120, and the third adhesive film layer 130 to obtain a yellowing index of the encapsulating film 100. For example, transmittance values of the encapsulating film 100 at wavelengths λ=445 nm, 555 nm, and 600 nm are measured through a spectrophotometer. The yellowing index Y = (T600-T445)/T555, and a yellowing index change value ΔYn = Yn - Y0, where Yn represents a yellowing index value after aging for n hours, and Y0 represents a yellowing index value before aging.

In an embodiment, in a comparative encapsulating film, a content of the UV absorber 200 is a, a content of the alkaline antacid agent 300 is b, a content of the UV absorber 200 in the first adhesive film layer is 50%*a, the content of the UV absorber 200 in the third adhesive film layer is 50%*a, the content of the alkaline antacid agent 300 in the first adhesive film layer is 50%*b, and the content of the alkaline antacid agent 300 in the third adhesive film layer is 50%*b. In an improved encapsulating film, a content of the UV absorber 200 is a, a content of the alkaline antacid agent 300 is b, the content of the UV absorber 200 in the first adhesive film layer is 100%*a, the content of the UV absorber 200 in the third adhesive film layer is 0, the content of the alkaline antacid agent 300 in the first adhesive film layer is 0, and the content of the alkaline antacid agent 300 in the third adhesive film layer is 100%*b. Yellowing tests are performed on the comparative encapsulating film and the improved encapsulating film, and the test results are shown in Table 1.

**Table 1: Yellowing indices of the comparative encapsulating film and the improved encapsulating film**

| Test condition | Yellowing Index of Improved Encapsulating Film | Yellowing Index of Comparative Encapsulating Film |
|---|---|---|
| UV60kWh/m² | 0.26 | 5.97 |
| UV120kWh/m² | 0.69 | 8.65 |
| UV240kWh/m² | 1.24 | 11.63 |
| UV75kWh/m²+DH500 | 0.86 | 7.97 |

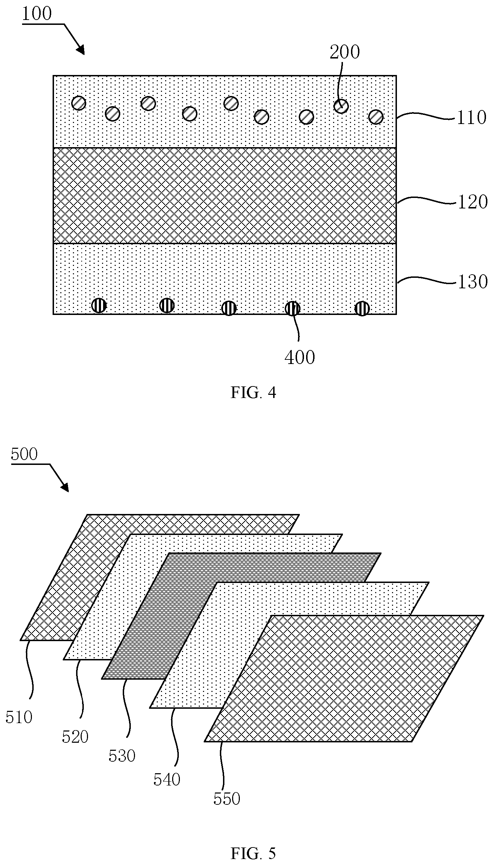

In an embodiment, as shown in FIG. 4, when an adhesive film layer of the encapsulating film 100 is bonded to a solar cell, the metal ions 400 from the solar cell diffuse into that adhesive film layer. However, the metal ions 400 are yellowing-causing components corresponding to the UV absorber 200 such as benzotriazole (C₆H₅N₃) containing an azo functional group (N=N), benzophenone (C₁₃H₁₀O) containing a carbonyl functional group (C=O), and triazine (C₃H₃N₃) containing an imino functional group (C=N).

In an embodiment, when the third adhesive film layer 130 is bonded to the solar cell, in order to avoid contact between the UV absorber 200 (such as benzotriazole (C₆H₅N₃) containing an azo functional group (N=N), benzophenone (C₁₃H₁₀O) containing a carbonyl functional group (C=O), and triazine (C₃H₃N₃) containing an imino functional group (C=N)) and the metal ions 400 diffused into the third adhesive film layer 130, the content of the UV absorber 200 in the third adhesive film layer 130 should be reduced. In order to ensure the overall UV-cutoff effect of the encapsulating film 100, while minimizing the content of the UV absorber 200 in the third adhesive film layer 130, the content of the UV absorber 200 in the first adhesive film layer 110 is correspondingly increased, so that the total content of the UV absorber 200 in the encapsulating film 100 remains unchanged.

In an embodiment, as shown in FIG. 4, when producing the first adhesive film layer 110, the UV absorber 200 is added so that the content of the UV absorber 200 in the first adhesive film layer 110 is greater than 90% of the total content of the UV absorber 200 in the encapsulating film 100, and may even reach 100%. When producing the third adhesive film layer 130, the UV absorber 200 is not added, so that the content of the UV absorber 200 in the third adhesive film layer 130 is less than 10% of the total content of the UV absorber 200 in the encapsulating film 100, and may even reach 0.

In an embodiment, the raw material formulation of the first adhesive film layer 110 includes ethylene-vinyl acetate copolymer (EVA), UV absorber 200, antioxidant, heat stabilizer, silane coupling agent, and crosslinking agent. Optionally, the raw material formulation of the first adhesive film layer 110 also includes a tackifying resin and/or a plasticizer. The raw material formulation of the third adhesive film layer 130 includes ethylene-vinyl acetate copolymer (EVA), antioxidant, heat stabilizer, silane coupling agent, and crosslinking agent. Optionally, the raw material formulation of the third adhesive film layer 130 also includes a tackifying resin and/or a plasticizer. The raw material formulation of the second adhesive film layer 120 includes polyolefin elastomer (POE), antioxidant, heat stabilizer, silane coupling agent, and crosslinking agent. Optionally, the raw material formulation of the second adhesive film layer 120 also includes a tackifying resin and/or a plasticizer.

In an embodiment, a thickness of the first adhesive film layer 110 ranges from 50 µm to 200 µm, for example, 50 µm, 80 µm, 150 µm or 200 µm. A thickness of the third adhesive film layer 130 is greater than or equal to the thickness of the first adhesive film layer 110, and the thickness of the third adhesive film layer 130 ranges from 100 µm to 200 µm, for example, 100 µm, 150 µm or 200 µm. The thickness of the second adhesive film layer 120 is greater than the thickness of the first adhesive film layer 110 and the third adhesive film layer 130, and the thickness of the second adhesive film layer 120 ranges from 150 µm to 250 µm, for example, 150 µm, 190 µm or 250 µm.

The present disclosure also provides a photovoltaic module 500, as shown in FIG. 5, including a front glass 510, a front encapsulating film 520, a solar cell 530, a back encapsulating film 540, and a backsheet 550 arranged in sequence. The front encapsulating film 520 and/or the back encapsulating film 540 includes the encapsulating film 100 according to the above embodiments. The encapsulating film 100 includes at least a first adhesive film layer 110, a second adhesive film layer 120, and a third adhesive film layer 130 arranged in sequence. The content of the UV absorber 200 in the first adhesive film layer 110 is different from the content of the UV absorber 200 in the third adhesive film layer 130, and the second adhesive film layer 120 is used for blocking diffusion of the UV absorber 200 from the first adhesive film layer 110 and/or the third adhesive film layer 130.

In an embodiment, the encapsulating film 100 is used for encapsulating the solar cell 530, the first adhesive film layer 110 is bonded to the front glass 510 and/or the backsheet 550, the third adhesive film layer 130 is bonded to the solar cell 530, and the content of the UV absorber 200 in the first adhesive film layer 110 is greater than the content of the UV absorber 200 in the third adhesive film layer 130. For example, the content of the UV absorber 200 in the first adhesive film layer 110 is greater than 90% of the total content of the UV absorber 200 in the encapsulating film 100, and may even reach 100%; and the content of the UV absorber 200 in the third adhesive film layer 130 is less than 10% of the total content of the UV absorber 200 in the encapsulating film 100, and may even reach 0.

In an embodiment, a potential induced degradation (PID) test is performed on a comparative photovoltaic module using the comparative encapsulating film according to the above embodiments and an improved photovoltaic module using the improved encapsulating film according to the above embodiments. The test conditions are 85°C, 85% RH, and a voltage of - 1500 V is applied. The test results are shown in Table 2.

**Table 2: Power attenuation of the comparative photovoltaic module and the improved photovoltaic module**

| Test condition | Power attenuation of comparative photovoltaic module | Power attenuation of improved photovoltaic module |
|---|---|---|
| DH1000 | 1.25% | 1.25% |
| UV240kWh/m2 | 9.05% | 1.89% |
| UV75kWh/m2+DH500 | 3.55% | 1.09% |

According to the encapsulating film and photovoltaic module provided by the present invention, by making the content of the UV absorber different in different adhesive film layers of the encapsulating film, and arranging an adhesive film layer for blocking diffusion of the UV absorber between the different adhesive film layers containing the UV absorber is prevented from contacting with the UV absorber and other components in the encapsulating film that may chemically react with or catalyze the UV absorber, thereby preventing yellowing of the encapsulating film, and thus improving the service life of the encapsulating film and enhancing the efficiency of the photovoltaic module.

It should be noted that the above embodiments are for illustrative purposes only, and are not intend to limit the present invention.

The various embodiments in this specification are described in a progressive manner, with each embodiment focusing on its differences from other embodiments, and the same or similar parts between the embodiments may be referred to each other.

The technical features of the above-described embodiments may be combined arbitrarily. To simplify the description, not all possible combinations of the technical features in the above embodiments are described. However, as long as there is no contradiction in the combination of these technical features, it should be considered as falling within the scope of this specification.

The above-described embodiments are merely several implementations of the present invention, and their description is specific and detailed, but should not be construed as limiting the protect scope of the patent application. It should be noted that, for those with ordinary skill in the art, several variations and improvements may be made without departing from the concept of the present invention, and these all fall within the protection scope of the present invention.

## Claims

1. An encapsulating film (100), comprising at least a first adhesive film layer (110), a second adhesive film layer (120) and a third adhesive film layer (130) arranged in sequence, wherein a content of a ultraviolet (UV) absorber (200) in the first adhesive film layer (110) is different from a content of the UV absorber (200) in the third adhesive film layer (130), and the second adhesive film layer (120) is configured to block diffusion of the UV absorber (200) from in first adhesive film layer (110) and/or the third adhesive film layer (130).

2. The encapsulating film (100) according to claim 1, wherein the third adhesive film layer (130) is configured to bond to a solar cell (530), the first adhesive film layer (110) is arranged on a side of the second adhesive film layer (120) away from the solar cell (530), and the content of the UV absorber (200) in the first adhesive film layer (110) is greater than the content of the UV absorber (200) in the third adhesive film layer (130).

3. The encapsulating film (100) according to claim 2, wherein the content of the UV absorber (200) in the first adhesive film layer is greater than 90% of a total content of the UV absorber (200) in the encapsulating film (100), and the content of the UV absorber (200) in the third adhesive film layer (130) is less than 10% of the total content of the UV absorber (200) in the encapsulating film (100).

4. The encapsulating film (100) according to claim 2, wherein the content of the UV absorber (200) in the first adhesive film layer (110) is 100% of a total content of the UV absorber (200) in the encapsulating film (100), and the content of the UV absorber (200) in the third adhesive film layer (130) is 0.

5. The encapsulating film (100) according to any one of claims 1 to 4, wherein the UV absorber (200) comprises functional groups for absorbing an ultraviolet light, and the functional groups for absorbing the ultraviolet light comprise at least one of an o-hydroxybenzoate functional group, an azo functional group, a carbonyl functional group, and an imino functional group; and preferably
the UV absorber (200) comprises at least one of a salicylic acid, a benzotriazole, a benzophenone and a triazine.

6. The encapsulating film (100) according to any one of claims 1 to 5, further comprising an alkaline antacid agent (300); and preferably
the alkaline antacid agent (300) comprises at least one of a magnesium oxide, an aluminum oxide, a zinc oxide, a barium sulfate and a titanium oxide.

7. The encapsulating film (100) according to claim 6, wherein the third adhesive film layer (130) is configured to bond to a solar cell (530), the first adhesive film layer (110) is arranged on a side of the second adhesive film layer (120) away from the solar cell (530), and a content of the alkaline antacid agent (300) in the third adhesive film layer (130) is greater than a content of the alkaline antacid agent (300) in the first adhesive film layer (110).

8. The encapsulating film (100) according to claim 7, wherein the content of the alkaline antacid agent (300) in the third adhesive film layer (130) is greater than 90% of a total content of the alkaline antacid agent (300) in the encapsulating film (100), and the content of the alkaline antacid agent (300) in the first adhesive film layer (110) is less than 10% of the total content of the alkaline antacid agent (300) in the encapsulating film (100).

9. The encapsulating film (100) according to claim 8, wherein the content of the alkaline antacid agent (300) in the third adhesive film layer (130) is 100% of a total content of the alkaline antacid agent (300) in the encapsulating film (100), and the content of the alkaline antacid agent (300) in the first adhesive film layer (110) is 0.

10. The encapsulating film (100) according to any one of claims 1 to 9, wherein the first adhesive film layer (110) and the third adhesive film layer (130) have a same polarity as the UV absorber (200), and the second adhesive film layer (120) has a different polarity from the UV absorber (200); and preferably
the first adhesive film layer (110), the third adhesive film layer (130) and the UV absorber (200) are polar substances, and the second adhesive film layer (120) is a non-polar substance.

11. The encapsulating film (100) according to any one of claims 1 to 10, wherein a main component of the first adhesive film layer (110) and the third adhesive film layer (130) comprises an ethylene-vinyl acetate copolymer, and a main component of the second adhesive film layer (120) comprises a polyolefin elastomer.

12. The encapsulating film (100) according to any one of claims 1 to 11, wherein a raw material formulation of the first adhesive film layer (110) comprises, by mass percentage: 93%~96% of an ethylene-vinyl acetate copolymer, 0.5%~3% of the UV absorber (200), 0.5%-1% of an antioxidant, 0.8%-1% of a heat stabilizer, 0.5%~1.5% of a silane coupling agent, 0.5%~0.8% of a crosslinking agent, 0%~0.5% of a tackifying resin, and 0~1.5% of a plasticizer.

13. The encapsulating film (100) according to any one of claims 1 to 12, wherein a raw material formulation of the third adhesive film layer (130) comprises, by mass percentage: 93%~96% of an ethylene-vinyl acetate copolymer, 1.5%~2% of an alkaline antacid agent (300), 0.5%~1% of an antioxidant, 0.8%~1% of a heat stabilizer, 0.5%~1.5% of a silane coupling agent, 0.5%~0.8% of a crosslinking agent, 0%~0.5% of a tackifying resin, and 0%~1.5% of a plasticizer.

14. The encapsulating film (100) according to any one of claims 1 to 13, wherein a raw material formulation of the second adhesive film layer (120) comprises, by mass percentage: 93%~97% of a polyolefin elastomer, 0.5%~1% of an antioxidant, 0.8%~1% of a heat stabilizer, 0.5%~1.5% of a silane coupling agent, 0.5%~0.8% of a crosslinking agent, 0%~0.5% of a tackifying resin, and 0%~1.5% of a plasticizer.

15. A photovoltaic module, comprising a front glass (510), a front encapsulating film (520), a solar cell (530), a back encapsulating film (540), and a backsheet (550) arranged in sequence, wherein the front encapsulating film (520) and/or the back encapsulating film (540) comprises the encapsulating film (100) according to any one of claims 1 to 14.
